# EUROPÄISCHE PATENTSCHRIFT

(11) **EP 0 905 786 B1**
(45) Veröffentlichungstag und Bekanntmachung des Hinweises auf die Patenterteilung: **06.02.2002**
(21) Anmeldenummer: 98117940.1
(22) Anmeldetag: 22.09.1998
(51) Int. Cl.: H01L 27/115, H01L 21/3205

(54) **Kondensator mit einer Barriereschicht aus einem Übergangsmetall Phosphid, -Arsenid oder -Sulfid**
Capacitor having a barrier layer of transition metal phosphide, arsenide, or sulphide
Condensateur ayant une couche de barrière d'un phosphure, d'un arséniure, our d'un sulfure d'un métal de transition

(30) Priorität: 30.09.1997 DE 19743268
(43) Veröffentlichungstag der Anmeldung: 31.03.1999
(73) Patentinhaber: Infineon Technologies AG, 81669 München (DE)
(72) Erfinder: Hintermaier, Frank, 81373 München (DE)
(74) Vertreter: Zimmermann & Partner

(56) Entgegenhaltungen:
- EP-A- 0 697 720
- US-A- 5 293 510

## Beschreibung

Die Erfindung betrifft einen Kondensator in einer integrierten Schaltung, insbesondere in einem integrierten Halbleiterspeicher.

In integrierten Schaltungen stellt sich oft die Aufgabe, einen Kondensator mit geringem Platzbedarf bei ausreichend hoher Kapazität herzustellen. Als Kondensatordielektrikum werden daher zunehmend keramische Dünnschichten mit hoher Dielektrizitätskonstante eingesetzt. Es handelt sich dabei meist um Oxyde, wie beispielsweise Strontiumtitanat (ST) oder Bariumstrontiumtitanat (BST) mit typischen ε-Werten im Bereich von 200 bis 600. Wird ein Kondensator mit ferroelektrischen Speichereigenschaften gewünscht, wird als Kondensatordielektrikum eine keramische Schicht mit geeigneten ferroelektrischen Eigenschaften verwendet, beispielsweise Strontium-Wismuth-Tantalat (SBT). Wie beispielsweise im Japanese Journal of Applied Physics, Vol. 34 (1995), Seiten 5224 bis 5229 beschrieben, werden diese keramischen Schichten üblicherweise durch Hochtemperaturprozesse in einer sauerstoffhaltigen Atmosphäre hergestellt.

Daher muß zumindest die untere (erste) Elektrode, auf die das Dielektrikum aufgebracht wird, unter diesen Bedingungen stabil sein. Als geeignet haben sich Platin, Platinmetalle (Ru, Ir) oder elektrisch leitfähige Metalloxide (RuO₂, IrO₂) erwiesen. Diese Elektrodenmaterialien sind jedoch für Sauerstoff durchlässig, so daß die Oberfläche von angrenzenden Strukturen, beispielsweise in dem oben erwähnten Hochtemperaturprozeß, oxidieren können. Wird wie üblich, die erste Elektrode bei einer Anschlußstruktur aus Polysilizium oder Wolfram mit anderen Schaltungselementen der integrierten Schaltung verbunden, oxidiert die Grenzschicht zwischen Anschlußstruktur und Elektrode, wodurch der Widerstand merklich erhöht wird oder eine elektrische Unterbrechung eintritt. Wird TiN als Silizium-Diffusionsbarriere unter der Elektrode eingesetzt, oxidiert diese während des Hochtemperaturprozesses, wie in der oben angegebenen Literaturstelle ebenfalls erläutert wird.

Barriereschichten aus TiN, TiSiN, TiO sind in EP-A-0697720 und US-A-5293510 beschrieben.

Aufgabe der Erfindung ist daher die Schaffung eines Kondensators mit hoher Kapazität bei geringem Platzbedarf, bei dem die genannten Probleme nicht auftreten. Diese Aufgabe wird durch einen Kondensator mit den Merkmalen des Patentanspruchs 1 und durch Herstellverfahren mit den Merkmalen der Patentansprüche 9 oder 10 gelöst.

Die Erfindung beruht auf dem Einsatz einer Barriereschicht, die im wesentlichen aus einer Verbindung zwischen einem Übergangselement (erste bis achte Nebengruppe des Periodensystems) einerseits und Phosphor, Schwefel oder Arsen andererseits besteht, es handelt sich also um Übergangsmetallphosphide, -Sulfide oder -Arsenide. Die Barriereschicht muß elektrisch leitfähig sein und eine ausreichende Beständigkeit gegen Oxidation aufweisen, ferner muß sie die Diffusion von Sauerstoff ausreichend verringern. Diese Eigenschaften wurden für die genannten Substanzklassen nachgewiesen. Besonders für die Phosphide der frühen Übergangselemente (Ti, Zr, Hf, V, Nb, Ta, Cr, Mo, W) wurde eine hohe Stabilität gegenüber Säuren und Laugen und gegenüber Oxidation nachgewiesen (S. Motojima, T. Wakamatsu, K. Sugiyama , J. Less Comm. Met. 1981, 82, 379 und S. Motojima et al., J. Mater. Sci. 1996, 31(21), S. 5709-5715) Beispielsweise betragen die Temperaturgrenzen, bis zu denen die Verbindungen gegen eine Oxidation an Luft stabil sind, bei TiP 350°C, bei MoP 450°C, bei WP 600° C und bei HfP 1000°C. Auch die Zersetzungstemperaturen sind sehr hoch (größer 1300°C) viele Phosphide sind stabiler als die entsprechenden Nitride (beispielsweise CrP, MoP, WP). Ferner sind sie leitfähig, der spezifische Widerstand der Raumtemperatur beträgt meist wenige mΩ/cm (R. L. Ripley, J. Less Comm. Met. 1962, 4, 496). Die Eigenschaften der Übergangsmetall-Sulfide und -Arsenide sind denen der entsprechenden Phosphide grundsätzlich ähnlich.

Es können auch Gemische aus den genannten Verbindungen als Barriere eingesetzt werden, bspw. WP/TiP. Die genannten Verbindungen können ferner - zur Erzielung gewünschter Eigenschaften - dotiert werden, insbesondere mit anderen Metallen.

Für die Herstellung von Schichten aus den genannten Substanzen existieren sowohl physikalische Prozesse, beispielsweise Sputterprozesse, als auch chemische Verfahren wie beispielsweise CVD. In dem Artikel von I.M. Watson, J.A. Connor, R. Whyman, Thin Solid Films, 1991, 196, L21. ist ein CVD-Verfahren für die Herstellung von CrP beschrieben, das als Precursor Cr(CO)₅(PH₃) in einem Ofen (200 bis 350°C, 0,8 tor) verwendet, wobei sich eine Abscheiderate von einigen µ/h ergibt. Für die Herstellung von TiP auf Silizium oder Siliziumoxid ist in dem Artikel von C.H. Winter, T.S. Lewkebandara, J.W. Proscia, Chem. Mater. 1995, 7, 1053. ein Abscheideverfahren beschrieben, das von TiCl₄(PH₂Cy)₂ als Ausgangssubstanz ausgeht (Cy = Cyclohexyl). Weitere Daten des Prozesses sind eine Temperatur von 350 bis 600°C und ein Druck von 0,1 tor. Weitere Herstellverfahren sind in den Ausführungsbeispielen angegeben.

Die Herstellung von Sulfiden und Arseniden kann analog erfolgen, also insbesondere durch Temperung in einer Atmosphäre, die H₂S bzw. AsH₃ enthält, oder durch einen CVD-Prozeß mit den Metallchloriden, H₂ und H₂S bzw. AsH₃.

Die Barriereschicht ist unterhalb des Kondensatordielektrikums und oberhalb der nächstfolgenden nicht oxidationsbeständigen Struktur angeordnet. Bei einer ggf. vorhandenen Anschlußstruktur ist sie vorzugsweise oberhalb dieser angeordnet, also zwischen Anschlußstruktur und erster Elektrode oder zwischen erster Elektrode und Kondensatordielektrikum.

Bei einer Anschlußstruktur aus einem oxidationsbeständigen Material kann die Barriereschicht auch unterhalb dieser angeordnet sein, z. B. an der Grenzfläche zu diesem Substrat. Wird auf eine Anschlußstruktur verzichtet, kann die Barriereschicht auch zwischen Elektrode und Substrat angeordnet sein. In jedem Fall muß die Barriereschicht so angeordnet und dimensioniert sein, daß bei der Herstellung des Kondensatordielektrikums Diffusionspfade für Sauerstoff wirksam unterbrochen sind. Sie muß also immer die gesamte Grenzfläche zwischen den betroffenen Strukturen bedecken (beispielsweise mindestens die gesamte Grenzfläche zwischen erster Elektrode und Kondensatordielektrikum oder zwischen Anschlußstruktur und erster Elektrode).

Bei Einsatz in einer integrierten Halbleiterschaltung mit mehreren Kondensatoren dürfen benachbarte Kondensatoren nicht durch die Barriereschicht kurzgeschlossen werden. Sie muß daher in geeigneter Weise strukturiert vorliegen. Dies kann entweder durch eine selektive Herstellung oder durch eine ganzflächige Herstellung mit anschließender Ätzung erreicht werden. Beispielsweise sind Ion-Milling oder Sputter-Ätzen geeignet, die rein physikalische Ätzmethoden darstellen. Mit einer alkalischen Ätzlösung ist ferner ein naßchemisches Ätzverfahren möglich.

Als Material für die Anschlußstruktur kommt insbesondere Polysilizium oder Wolfram in Betracht. Die erste Elektrode besteht vorzugsweise aus einem Pt-haltigen, Ru-haltigen, Rh-haltigen oder Ir-haltigen Material. Für das Dielektrikum kann u.a. BST ( (Ba, Sr)TiO₃ ), SBT ( SrBi₂Ta₂O₉ ), PZT ( Pb(Zr, Ti)O₃ ) oder PLT ( La-dotiertes PZT ) eingesetzt werden.

Die Erfindung wird im folgenden anhand von Ausführungsbeispielen, die in den Zeichnungen dargestellt sind, näher erläutert.

FIG 1 und 2 zeigen eine Speicherzelle einer integrierten Halbleiterschaltung mit einem Kondensator gemäß einer ersten Ausführungsform der Erfindung.

FIG 3 und 4 zeigen ein weiteres Ausführungsbeispiel.

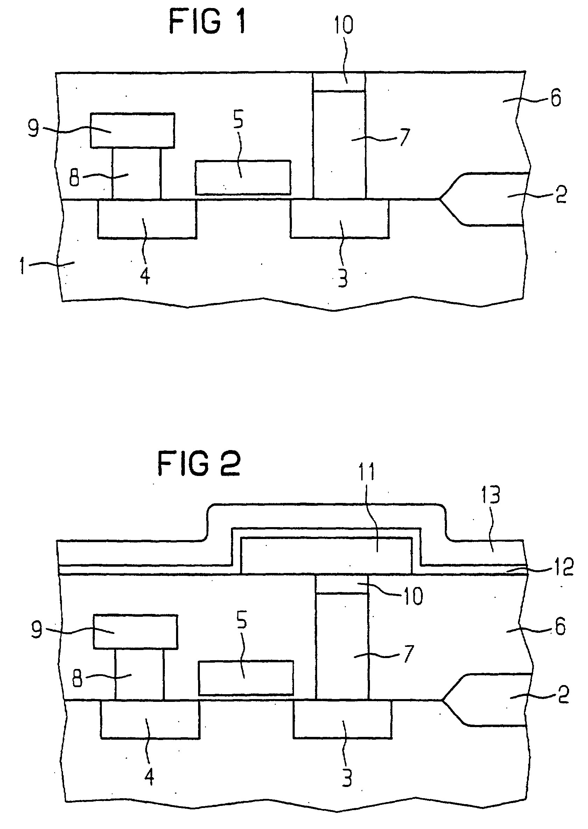

FIG 1: Der Kondensator wird als Speicherkondensator in einem integrierten Halbleiterspeicher, insbesondere einem DRAM oder FRAM, eingesetzt. Die Figur zeigt ein Siliziumsubstrat 1 mit einem darauf angeordneten MOS-Transistor, der zwei dotierte Gebiete 3, 4 und ein isoliert auf dem Substrat aufgebrachtes Gate 5 umfaßt. Nichtaktive Bereiche der Schaltung sind mit einer Isolation 2 bedeckt. Eine Isolationsschicht 6 bedeckt den Transistor, wobei eine Anschlußstruktur 7 zum dotierten Gebiet 3 vorgesehen ist. Das andere dotierte Gebiet 4 ist über eine weitere Anschlußstruktur 8 mit einer Bitleitung 9 verbunden. In diesem Fall besteht die Anschlußstruktur 7 aus Wolfram, mit dem ein in die Isolationsschicht 6 geätztes Kontaktloch aufgefüllt wird. Die Isolationsschicht 6 kann aus Siliziumoxid oder -Nitrid bestehen. Zur Herstellung der Barriereschicht wird die nun vorliegende Struktur in einer PH₃-Athmosphäre getempert. Dabei reagiert das W mit dem PH₃, so daß WP 10 auf der Anschlußstruktur 7 in selbstjustierter Weise gebildet wird. Typische Parameter für die Temperung sind eine Temperatur von 800 bis 1100°C und ein Druck von 0,1 bis 10 tor PH₃. Ein Teil der Anschlußstruktur 7 wird also direkt in WP überführt. Die Schichtdicke der Barriere 10 kann über die Zeitdauer der Temperung eingestellt werden, ein typischer Wert ist etwa 30 nm.

FIG 2: Nun wird die untere Elektrode 11 des Kondensators aufgebracht, beispielsweise durch Sputtern einer etwa 30 nm dikken Pt-Schicht und geeignete Strukturierung. Anschließend wird ein hoch-ε-Dielektrikum 12 abgeschieden, wobei nun das Wolframphosphid während des Abscheidens als Barriere gegen eindiffundierenden Sauerstoff wirkt und die Oxidation der Anschlußstruktur 7 verhindert. Schließlich wird eine zweite Elektrode 13 des Kondensators beispielsweise aus Platin hergestellt. Im beschriebenen Beispiel stellt sie die sogenannte Commonplate für alle Kondensatoren dar.

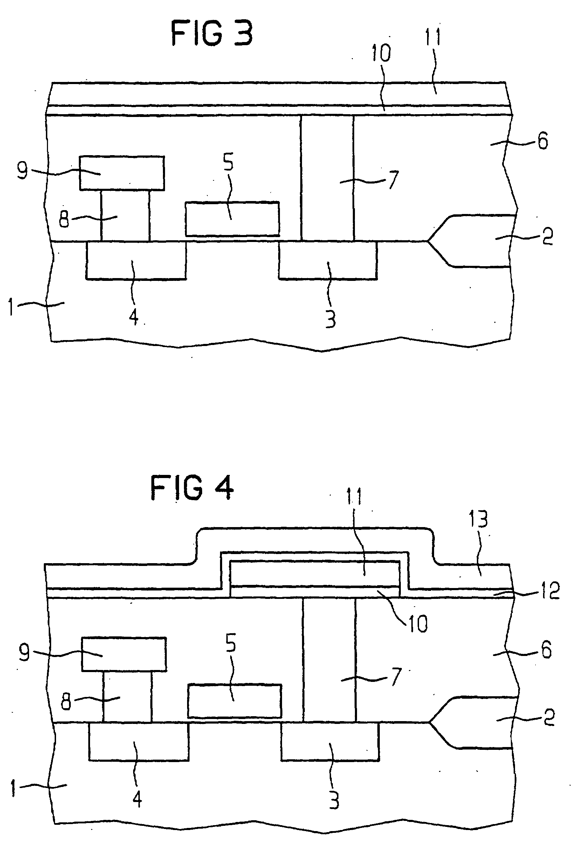

FIG 3: Beim zweiten Ausführungsbeispiel wird von der gleichen vorgefertigten Grundstruktur wie beim ersten Ausführungsbeispiel ausgegangen, also einem Substrat mit einem MOS-Transistor, der mit einer Isolationsschicht 6 abgedeckt ist, wobei eine Anschlußstruktur 7 durch diese Isolationsschicht 6 hindurch mit einem dotierten Gebiet 3 des Transistors verbunden ist. Auf diese Struktur wird nun die Barriereschicht 10 ganzflächig durch eine CVD-Abscheidung aufgebracht. Dazu wird ein Gemisch von Wolfram-Chlorid (WCl₆), Wasserstoff (H₂) und Phosphin (PH₃) in einer Kammer erzeugt. Bei einer Temperatur von 400 bis 800°C und einem Druck von 0,1 bis 10 tor wird Wolframphosphid (WP) auf der gesamten Oberfläche abgeschieden. Alternativ kann auch Tantalphosphid aus den Ausgängsmaterialien TaCl₅, H₂ und PH₃ in einem CVD-Prozeß abgeschieden werden. Darauf wird als Material der unteren Elektrode 11 Platin aufgebracht.

FIG 4: Die beiden Schichten 10, 11 werden mit Hilfe einer Phototechnik in einem Ätzprozeß strukturiert, so daß eine erste Elektrode 11 gebildet wird, die dann auf der Barriereschicht 10 aufliegt. Wie im ersten Ausführungsbeispiel wird der Kondensator durch Herstellen des Kondensatordielektrikums 12 und der zweiten Elektrode 13 fertiggestellt.

Die Barriereschicht 10 kann auch auf der ersten Elektrode 11 angeordnet werden. Da sie in diesem Fall auch die Flanken der ersten Elektrode bedecken muß, wird zweckmäßigerweise zunächst die erste Elektrode strukturiert und dann die Barriereschicht aufgebracht. Die erste Elektrode und die Barriereschicht können aber auch gemeinsam strukturiert werden, dann müssen die Flanken der ersten Elektrode bspw. durch einen Spacer aus dem Material der Barriere abgedeckt werden.

## Patentansprüche

1. Kondensator in einer integrierten Halbleiterschaltung mit einer ersten Elektrode (11), die direkt oder über eine Anschlußstruktur (7) an ein dotiertes Gebiet (3) in einem Halbleitersubstrat (1) angeschlossen ist,
mit einer zweiten Elektrode (13),
mit einem Kondensatordielektrikum (12), das die erste und zweite Elektrode voneinander isoliert,
mit einer Barriereschicht (10), die im wesentlichen aus einer Verbindung zwischen einem Übergangselement und Phosphor, Schwefel oder Arsen besteht und zwischen dem Kondensatordielektrikum (12) und dem dotierten Gebiet (3) angeordnet ist.

2. Kondensator nach Anspruch 1, bei dem die Barriereschicht (10) direkt unterhalb des Kondensatordielektrikums (12) angeordnet ist und die gesamte Grenzfläche zwischen erster Elektrode (11) und Kondensatordielektrikum (12) bedeckt.

3. Kondensator nach Anspruch 1, bei dem die Barriereschicht (10) unterhalb der erstem Elektrode (11) angeordnet ist und die gesamte Grenzfläche zwischen erster Elektrode (11) und Anschlußstruktur (7) oder die gesamte Grenzfläche zwischen erster Elektrode (11) oder Anschlußstruktur (7) und dotiertem Gebiet (3) bedeckt.

4. Kondensator nach einem der Ansprüche 1 bis 3, bei dem das Kondensatordielektrikum aus einem dielektrischen oder ferroelektrischen Material mit einem Wert von ε > 100 , insbesondere BST, SBT, PZT oder PLT besteht.

5. Kondensator nach einem der Ansprüche 1 bis 4, bei dem die erste Elektrode aus einem Pt-haltigen, Ru-haltigen, Rh-haltigen oder Ir-haltigen Material besteht.

6. Kondensator nach einem der Ansprüche 1 bis 5, mit einer Anschlußstruktur (7) aus Polysilizium oder Wolfram.

7. Kondensator nach einem der Ansprüche 1 bis 8, bei dem die Barriereschicht im wesentlichen aus einer Wolfram-Phosphid-Schicht, einer Tantal-Phosphid-Schicht oder einer Hafnium-Phosphid-Schicht besteht.

8. Halbleiterspeicheranordnung mit einem Kondensator nach Patentanspruch 1 und einem zugeordneten Auswahltransistor (3, 4, 5), der das dotierte Gebiet (3) umfaßt.

9. Herstellverfahren für einen Kondensator in einer integrierten Halbleiterschaltung,
- bei dem auf einem Substrat (1) eine erste Elektrode (11) erzeugt wird, die ggf. über eine Anschlußstruktur (7) mit einem dotierten Gebiet (3) im Halbleitersubstrat (1) verbunden ist,
- bei dem auf dem dotierten Gebiet (3) oder auf der Anschlußstruktur (7) eine Barriereschicht (10) erzeugt wird, die im wesentlichen aus einer Verbindung zwischen einem Übergangselement und Phosphor, Schwefel oder Arsen besteht und die gesamte freiliegende Oberfläche des dotierten Gebietes (3) bzw. der Anschlußstruktur (7) bedeckt,
- bei dem auf der ersten Elektrode (11) ein Kondensatordielektrikum (12) erzeugt wird,
- bei dem auf dem Kondensatordielektrikum (12) eine zweite Elektrode (13) erzeugt wird.

10. Herstellverfahren für einen Kondensator in einer integrierten Halbleiterschaltung,
- bei dem auf einem Substrat (1) eine erste Elektrode (11) erzeugt wird, die direkt oder über eine Anschlußstruktur (7) mit einem dotierten Gebiet (3) im Halbleitersubstrat (1) verbunden ist,
- bei dem auf der ersten Elektrode (11) eine Barriereschicht (10) erzeugt wird, die im wesentlichen aus einer Verbindung zwischen einem Übergangselement und Phosphor, Schwefel oder Arsen besteht und die gesamte freiliegende Oberfläche der ersten Elektrode (11) bedeckt,
- bei dem auf der Barriereschicht (10) ein Kondensatordielektrikum (12) erzeugt wird,
- bei dem auf dem Kondensatordielektrikum (12) eine zweite Elektrode (13) erzeugt wird.

11. Verfahren nach einem der Ansprüche 9 bis 10, bei dem die Barriereschicht (10) auf einer aus Wolfram bestehenden Elektrode (11) oder auf einer aus Wolfram bestehenden Anschlußstruktur (7) durch Tempern in einer PH₃-Athmosphäre erzeugt wird.

12. Verfahren nach einem der Ansprüche 9 bis 10, bei dem die Barriereschicht (10) durch eine CVD-Abscheidung erzeugt wird.

13. Verfahren nach Anspruch 9, bei dem die Barriereschicht (10) ganzflächig aufgebracht wird und unter Verwendung der ersten Elektrode (12) als Maske in einem Ätzprozeß strukturiert wird.

14. Verfahren nach einem der Ansprüche 9 bis 13, bei dem das Kondensatordielektrikum (12) aus einem dielektrischen oder ferroelektrischen Material mit einem Wert von ε>100, insbesondere BST, SBT, PZT oder PLT, besteht.

## Claims

1. Capacitor in an integrated semiconductor circuit, having a first electrode (11), which is connected, directly or via a connection structure (7), to a doped region (3) in a semiconductor substrate (1),
having a second electrode (13),
having a capacitor dielectric (12) which insulates the first and second electrodes from one another,
having a barrier layer (10) which substantially comprises a compound between a transition element and phosphorus, sulphur or arsenic and is arranged between the capacitor dielectric (12) and the doped region (3).

2. Capacitor according to Claim 1, in which the barrier layer (10) is arranged directly beneath the capacitor dielectric (12) and covers the entire interface between first electrode (11) and capacitor dielectric (12).

3. Capacitor according to Claim 1, in which the barrier layer (10) is arranged beneath the first electrode (11) and covers the entire interface between first electrode (11) and connection structure (7) or the entire interface between first electrode (11) or connection structure (7) and doped region (3).

4. Capacitor according to one of Claims 1 to 3, in which the capacitor dielectric consists of a dielectric or ferroelectric material with a dielectric constant of ε > 100, in particular BST, SBT, PZT or PLT.

5. Capacitor according to one of Claims 1 to 4, in which the first electrode consists of a Pt-containing, Ru-containing, Rh-containing or Ir-containing material.

6. Capacitor according to one of Claims 1 to 5, having a connection structure (7) made from polysilicon or tungsten.

7. Capacitor according to one of Claims 1 to 8, in which the barrier layer substantially comprises a tungsten phosphide layer, a tantalum phosphide layer or a hafnium phosphide layer.

8. Semiconductor memory arrangement, having a capacitor according to Claim 1 and an associated select transistor (3, 4, 5) which comprises the doped region (3).

9. Method for fabricating a capacitor in an integrated semiconductor circuit,
- in which a first electrode (11), which is connected, if appropriate via a connection structure (7), to a doped region (3) in a semiconductor substrate (1), is generated on the substrate (1),
- in which a barrier layer (10), which substantially comprises a compound between a transition element and phosphorus, sulphur or arsenic and covers the entire exposed surface of the doped region (3) or of the connection structure (7), is generated on the doped region (3) or on the connection structure (7),
- in which a capacitor dielectric (12) is generated on the first electrode (11),
- in which a second electrode (13) is generated on the capacitor dielectric (12).

10. Method for fabricating a capacitor in an integrated semiconductor circuit,
- in which a first electrode (11), which is connected, directly or via a connection structure (7), to a doped region (3) in a semiconductor substrate (1), is generated on the substrate (1),
- in which a barrier layer (10), which substantially comprises a compound between a transition element and phosphorus, sulphur or arsenic and covers the entire exposed surface of the first electrode (11), is generated on the first electrode (11),
- in which a capacitor dielectric (12) is generated on the barrier layer (10),
- in which a second electrode (13) is generated on the capacitor dielectric (12).

11. Method according to one Claims 9 to 10, in which the barrier layer (10) is generated on an electrode (11) which consists of tungsten or on a connection structure (7) which consists of tungsten, by conditioning in a PH₃ atmosphere.

12. Method according to one of Claims 9 to 10, in which the barrier layer (10) is generated by CVD.

13. Method according to Claim 9, in which the barrier layer (10) is applied to the entire surface and is patterned in an etching process using the first electrode (12) as a mask.

14. Method according to one of Claims 9 to 13, in which the capacitor dielectric (12) consists of a dielectric or ferroelectric material with a dielectric constant of ε > 100, in particular BST, SBT, PZT or PLT.

## Revendications

1. Condensateur dans un circuit intégré à semi-conducteur comprenant une première électrode (11), qui est reliée directement ou par une structure (7) de raccordement à une zone (3) dopée d'un substrat (1) semi-conducteur,
comprenant une deuxième électrode (13),
comprenant un diélectrique (12) de condensateur qui isole l'une de l'autre la première et la deuxième électrode,
comprenant une couche (10) de barrière qui est constituée essentiellement d'un composé entre un élément de transition et le phosphore, le soufre ou l'arsenic et qui est interposée entre le diélectrique (12) du condensateur et la zone (3) dopée.

2. Condensateur suivant la revendication 1, dans lequel la couche (10) de barrière est disposée directement en-dessous du diélectrique (12) de condensateur et recouvre toute l'interface entre la première électrode (11) et le diélectrique (12) de condensateur.

3. Condensateur suivant la revendication 1, dans lequel la couche (10) de barrière est disposée en-dessous de la première électrode (11) et recouvre toute l'interface entre la première électrode (11) et la structure (7) de raccordement ou toute l'interface entre la première électrode (11) et la structure (7) de raccordement et la zone (3) dopée.

4. Condensateur suivant l'une des revendications 1 à 3, dans lequel le diélectrique du condensateur est en un matériau diélectrique ou ferroélectrique ayant une valeur de ε > 100, notamment en BST, SBT, PZT ou PLT.

5. Condensateur suivant l'une des revendications 1 à 4, dans lequel la première électrode est en un matériau contenant du Pt, contenant du Ru, contenant du Rh ou contenant du Ir.

6. Condensateur suivant l'une des revendications 1 à 5, comprenant une structure (7) de raccordement en polysilicium ou en tungstène.

7. Condensateur suivant l'une des revendications 1 à 8, dans lequel la couche de barrière est constituée essentiellement d'une couche de phosphure de tungstène, d'une couche de phosphure de tantale ou d'une couche de phosphure d'hafnium.

8. Dispositif de mémoire à semi-conducteur comprenant un condensateur suivant la revendication 1 et un transistor (3, 4, 5) de sélection qui lui est associé et qui comporte la zone (3) dopée.

9. Procédé de fabrication d'un condensateur dans un circuit intégré à semi-conducteur,
- dans lequel on produit sur un substrat (1) une première électrode (11) qui est reliée éventuellement par une structure (7) de raccordement à une zone (3) dopée du substrat (1) semi-conducteur,
- dans lequel on produit sur la zone (3) dopée ou sur la structure (7) de raccordement une couche (10) de barrière qui est essentiellement en un composé entre un élément de transition et le phosphore, le soufre ou l'arsenic et qui recouvre toute la surface dégagée de la zone (3) dopée ou de la structure (7) de raccordement,
- dans lequel on produit sur la première électrode (11) un diélectrique (12) de condensateur,
- dans lequel on produit sur le diélectrique (12) de condensateur une deuxième électrode (13).

10. Procédé de fabrication d'un condensateur dans un circuit intégré à semi-conducteur,
- dans lequel on produit sur un substrat (1) une première électrode (11) qui est reliée directement ou par l'intermédiaire d'une structure (7) de raccordement à une zone (3) dopée du substrat (1) semi-conducteur,
- dans lequel on produit sur la première électrode (11) une couche (10) de barrière qui est essentiellement en un composé entre un élément de transition et le phosphore, le soufre ou l'arsenic et qui recouvre toute la surface dégagée de la première électrode (11),
- dans lequel on produit sur la couche (10) de barrière un diélectrique (12) de condensateur,
- dans lequel on produit sur le diélectrique (12) de condensateur une deuxième électrode (13).

11. Procédé suivant l'une des revendications 9 à 10, dans lequel on produit la couche (10) de barrière sur une électrode (11) en tungstène ou sur une structure (7) de raccordement en tungstène par traitement thermique dans une atmosphère de PH₃.

12. Procédé suivant l'une des revendications 9 à 10, dans lequel on produit la couche (10) de barrière par un dépôt CVD.

13. Procédé suivant la revendication 9, dans lequel on dépose la couche (10) de barrière sur toute la surface et on la structure dans une opération d'attaque chimique en utilisant la première électrode (12) comme masque.

14. Procédé suivant l'une des revendications 9 à 13, dans lequel le diélectrique (12) de condensateur est en un matériau diélectrique ou ferroélectrique ayant une valeur de ε > 100, notamment en BST, SBT, PZT ou PLT.
